# EUROPEAN PATENT SPECIFICATION

(11) **EP 2 777 431 B1**
(45) Date of publication and mention of the grant of the patent: **09.03.2016**
(21) Application number: 13158750.3
(22) Date of filing: 12.03.2013
(51) Int. Cl.: A47B 88/04, H05K 7/14

(54) **Support structure for support bracket and rail**
Stützstruktur für Tragkonsole und Schiene
Structure de support pour console et rail

(43) Date of publication of application: 17.09.2014
(73) Proprietor: King Slide Works Co., Ltd., Kaohsiung City (TW); King Slide Technology Co., Ltd., Kaohsiung City (TW)
(72) Inventor: Chen, Ken-Ching, Kaohsiung City (TW); Yang, Shun-Ho, Kaohsiung City (TW); Huang, Chien-Li, Kaohsiung City (TW); Wang, Chun-Chiang, Kaohsiung City (TW)
(74) Representative: Viering, Jentschura & Partner mbB Patent- und Rechtsanwälte

(56) References cited:
- US-A1- 2002 158 556
- US-A1- 2003 209 959
- US-A1- 2011 091 141
- US-A1- 2012 076 446

## Description

### FIELD OF THE INVENTION

The present invention relates to a support structure.

### BACKGROUND OF THE INVENTION

A conventional support structure for the bracket and the rail is disclosed in U.S. Patent No. 7,188,916 "Adjustable Side Rails And Method of Attaching Same to Mounting Rails of Cabinet Racks" to Silvestro, U.S. Publication No. 2006/0152115 "Adjustable Reinforcing Bracket for Telescoping Slide Rail Assembly" to Dubon, and U.S. Publication No. 2008/0036347 "Rail Device for Extracting Computer Equipment" to Liang.

A support structure according to the preamble of claim 1 is known from US 2012/0076446 A1.

Generally, a slide assembly comprises telescoping multiple rails and the front and rear support brackets respectively connected to the front and rear ends of the slide assembly. The rear support bracket usually is movably connected to the rail so as to adjust the length of the slide assembly. When the slide assembly with the support brackets is used in the rack system for servers, the front and rear support brackets are connected to the rack, and a server is connected to the rail. A cable management arm is connected to the rear end of the rail so as to manage the cables of the server.

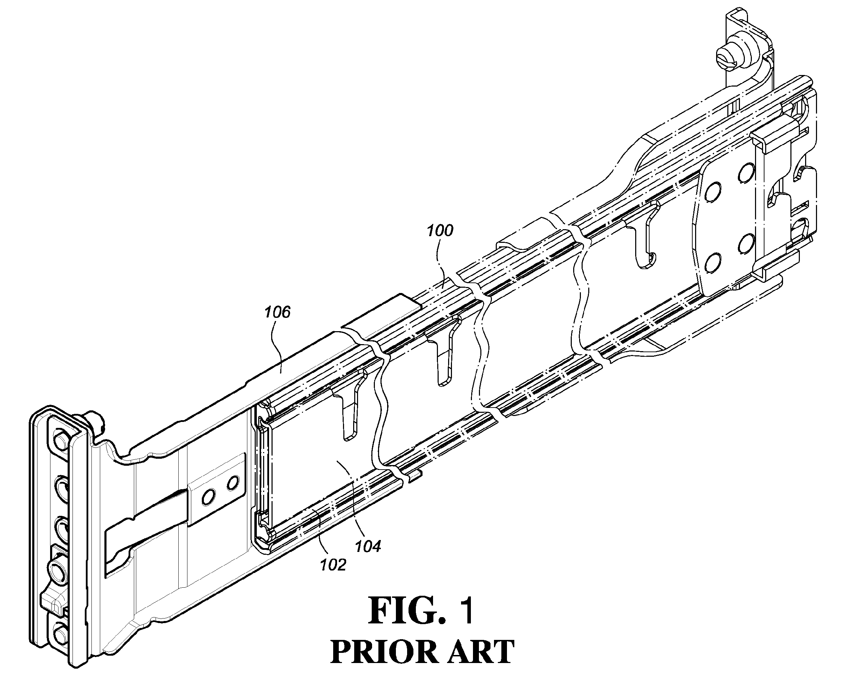

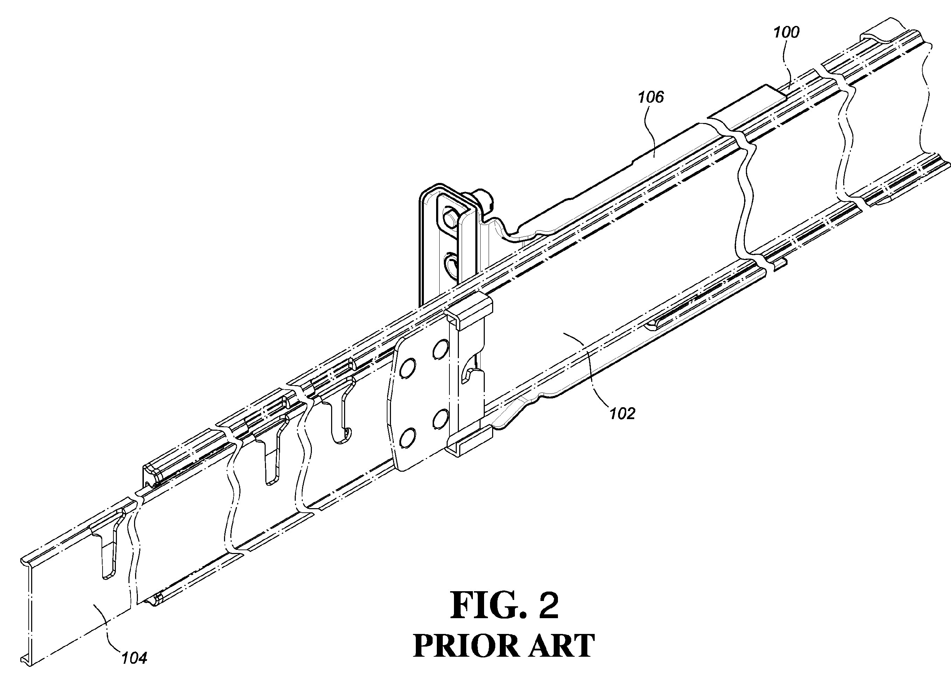

Fig. 1 shows the conventional slide assembly which comprises a first rail 100, a second rail 102, a third rail 104 and a front support bracket 106. The second rail 102 is slidably connected to the first rail 100, and the third rail 104 is slidably connected to the second rail 102. The front support bracket 106 is fixed to the first rail 100. The middle portion of the front support bracket 106 has related mechanical structure connected thereto. The front end of the first rail 100 is fixed to the rear section of the front support bracket 106. Fig. 2 shows that when the second rail 102 is pulled relative to the first rail 100, and passes the front support bracket 106, the middle portion of the front support bracket 106 is not in contact with the top and bottom portions of the second rail 102. The middle portion lacks strength from the contact between parts so that when a load is heavy, the support bracket and the extended rail are easily deformed to affect the stability of the whole slide assembly.

The present invention intends to provide a support structure with a support bracket and a rail.

### SUMMARY OF THE INVENTION

The present invention is defined by claim 1. According to this the present invention relates to a support structure comprising a support bracket and a first rail. A first support bracket has a first side portion and a first end board which is bent from the first side portion. The first side portion has a first connection section and a first extension section. The first connection section is connected to the first rail. The first extension section has two support portions between which a path is defined. The first end board has at least one front installation member. A second rail is slidably connected to the first rail. The second rail has two sidewalls and a second lateral wall. The second lateral wall is connected between the two sidewalls. The second rail is pulled relative to the first rail and movable along the path. A support member is connected to one of the support portions of the first support bracket. Two support members are respectively connected to the support portions of the first support bracket and the support members have a curved face facing the second sidewalls of the second rail so as to be engaged with the second sidewall of the second rail. When the second rail is pulled to a position in the path of the first support bracket, the curved support face of the support member supports and contacts the second rail.

The present invention also provides a slide assembly comprising a support structure according to the invention. Said slide assembly also comprises a second support bracket which has a second side portion and a second end board. The second side portion is connected to the rear end of the first rail. The second end board has at least one rear installation member. A third rail is slidably connected to the second rail and has multiple positioning holes.

According to the invention there are two support members which are respectively connected to the support portions of the first support bracket and each of the support members have curved support face so as to be engaged with the second sidewall of the second rail corresponding thereto.

According to the invention the support member and the first support bracket are two separated/individual parts. Preferably the support members extend from the first support bracket.

Preferably, the support member is connected to the first support bracket is by way of welding, riveting or engaging.

The present invention will become more obvious from the following description when taken in connection with the accompanying drawings which show, for purposes of illustration only, a preferred embodiment in accordance with the present invention.

### BRIEF DESCRIPTION OF THE DRAWINGS

Fig. 1 shows the conventional rail and the support bracket;
Fig. 2 shows that the conventional rail is pulled relative to the support bracket;
Fig. 3 is a perspective view to show the rail and the support bracket not according to the present invention;
Fig. 4 is a cross sectional view of the rail and the support bracket not according to the present invention;
Fig. 5 is a cross sectional view to show that the rail is pulled relative to the support bracket not according to the present invention;
Fig. 6 shows the first embodiment of the rail and the support bracket of the present invention;
Fig. 7 shows the second embodiment of the rail and the support bracket of the present invention, and
Fig. 8 shows the third embodiment of the rail and the support bracket of the present invention.

### DETAILED DESCRIPTION OF THE PREFERRED EMBODIMENT

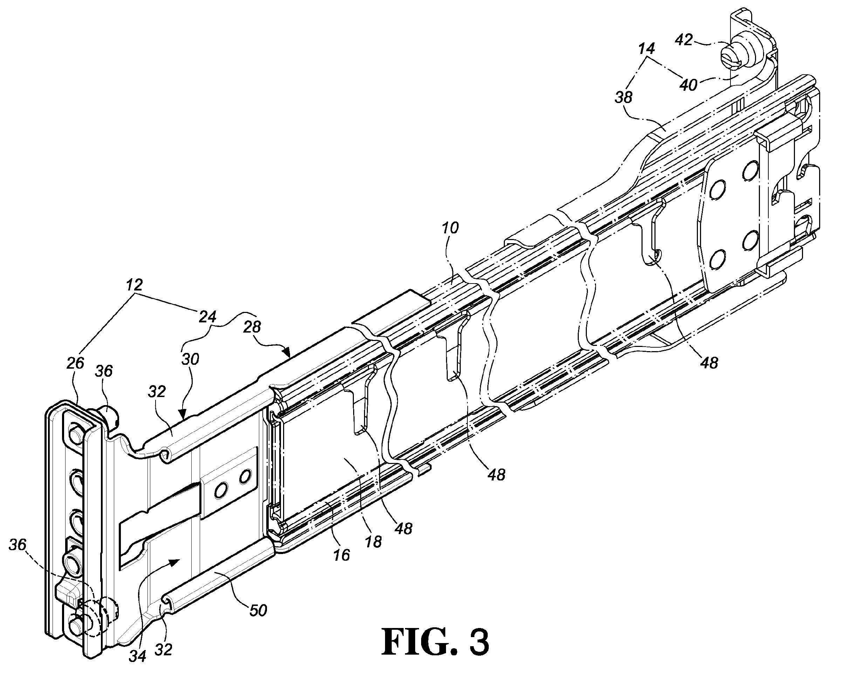

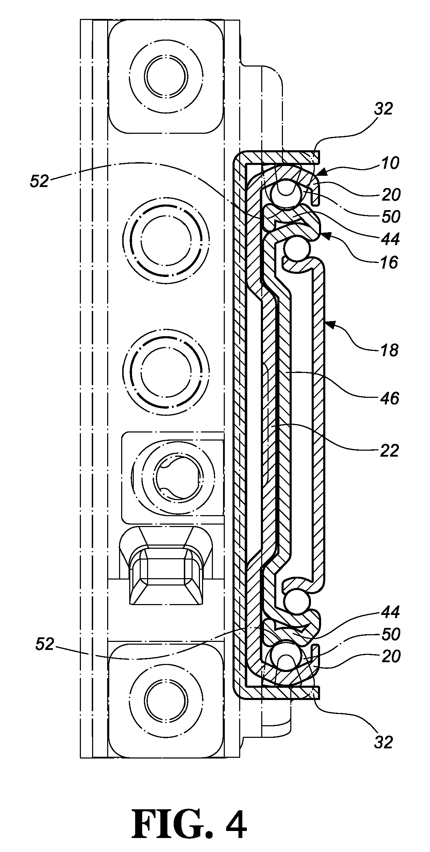

Referring to Figs. 3 and 4, slide assembly not according to the invention comprises a first rail 10, a first support bracket 12, a second support bracket 14, a second rail 16 and a third rail 18.

The first rail 10 comprises two first sidewalls 20 and a first lateral wall 22 which is connected between the two first sidewalls 20.

The first support bracket 12 comprises a first side portion 24 and a first end board 26 which is bent from the first side portion 24. The first side portion 24 is connected to a front end of the first rail 10. The first side portion 24 has a first connection section 28 and a first extension section 30, wherein the first connection section 28 is connected to the first rail 10. The first extension section 30 has two support portions 32 between which a path 34 is defined. The first end board 26 has at least one first installation member 36 which is installed to the front end of a rack (not shown).

The second support bracket 14 comprises a second side portion 38 and a second end board 40. The second end board 40 is bent from the second side portion 38. The second side portion 38 is connected to the rear end of the first rail 10. The second end board 40 has at least one rear installation member 42 which is installed to the rear end of a rack (not shown).

The second rail 16 is slidably connected to the first rail 10. The second rail 16 has two second sidewalls 44 and a second lateral wall 46. The second lateral wall 46 is connected between the two second sidewalls 44.

The third rail 18 is slidably connected to the second rail 16 and has multiple positioning holes 48 so as to be connected with equipment such as a chassis (not shown).

It is noted that at least one support member 50 is connected to one of the support portions 32 of the first support bracket 12 and located in the path 34 of the first support bracket 12. The support member 50 is located corresponding to one of the second sidewalls 44 of the second rail 16.

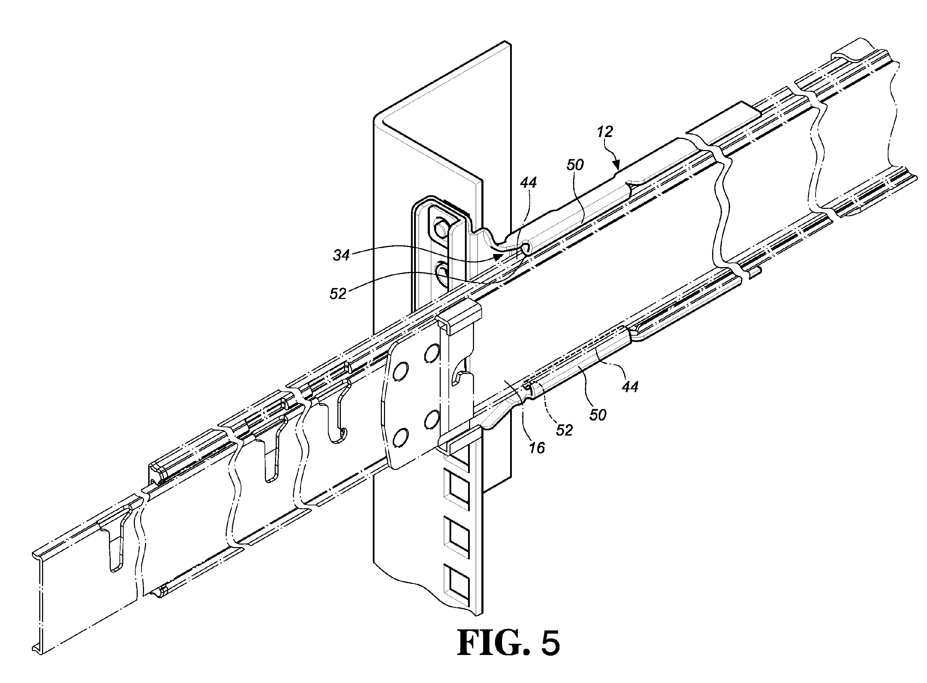

Fig. 5 shows that when the second rail 16 is pulled, relative to the first rail 10, to a position in the path 34 of the first support bracket 12 and contacts the support member 50, the support member 50 contacts the second sidewalls 44 and supports the second rail 16. When used in a rack system, the rails and the chassis loaded thereon are pulled out from the rack, the first support bracket 12 contacts and supports the second rail 16 by the support member 50, so as to reinforce the ability for bearing the load between the rails and the support bracket.

As shown in Fig. 4, there are two support members 50 which are respectively connected to the support portions 32 of the first support bracket 12.

As shown in Figs. 4 and 5, the support members 50 extend directly from the support portions 32 of the first support bracket 12. Each support member 50 has a curved support face 52 facing the second sidewall 44 of the second rail 16 so as to be engaged with the second sidewall 44 of the second rail 16 corresponding thereto.

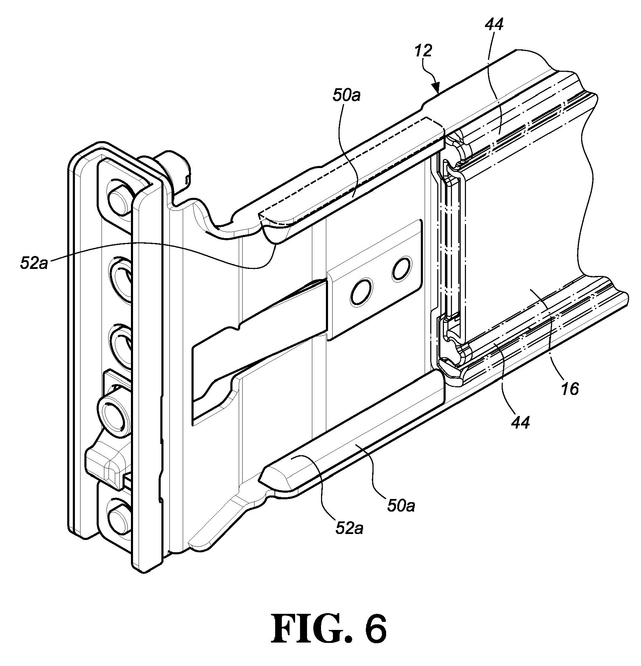

Fig. 6 shows the first embodiment of the present invention, wherein the support member 50a and the first support bracket 12 are individual parts. The support member 50a is securely connected to the first support bracket 12 by way of welding. The support member 50a can be a metallic part or made by any material which can be welded to the first support bracket 12. The support member 50a has a curved support face 52a so as to be engaged with the second sidewall 44 of the second rail 16 corresponding thereto.

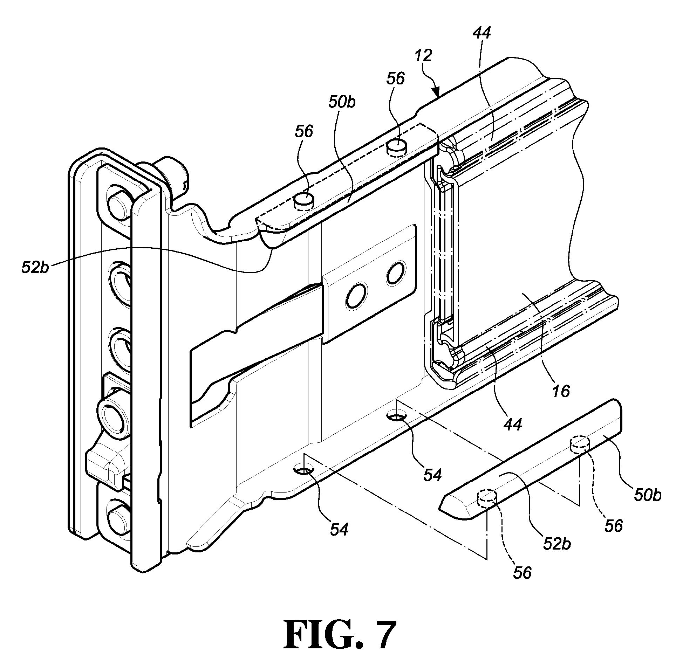

Fig. 7 shows the second embodiment of the present invention, wherein the support member 50b and the first support bracket 12 are individual parts. The support member 50b is fixedly connected to the first support bracket 12 by way of riveting. The first support bracket 12 has multiple engaging holes 54, and the support member 50b has protrusions 56 which are riveted in the engaging holes 54 so as to fix the support member 50b to the first support bracket 12. The support member 50b can be a plastic or metallic part. The support member 50b has a curved support face 52b so as to be engaged with the second sidewall 44 of the second rail 16 corresponding thereto.

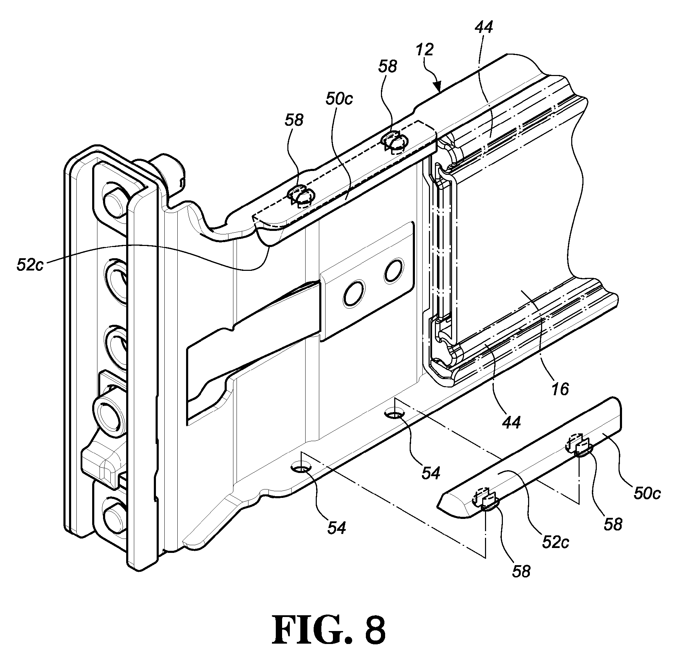

Fig. 8 shows the third embodiment of the present invention, wherein the support member 50c and the first support bracket 12 are individual parts. The support member 50c is fixedly connected to the first support bracket 12 by way of engaging. The first support bracket 12 has multiple engaging holes 54 and the support member 50c has latches 58 which are inserted into the engaging holes 54 so as to connect the support member 50c to the first support bracket 12. The latches 58 preferably are flexible such as plastic. The support member 50c has a curved support face 52c so as to be engaged with the second sidewall 44 of the second rail 16 corresponding thereto.

While we have shown and described the embodiment in accordance with the present invention, it should be clear to those skilled in the art that further embodiments may be made without departing from the scope of the present invention as defined in the appended claims.

## Claims

1. A support structure comprising:
a first rail (10);
a first support bracket (12) having a first side portion (24) and a first end board (26) which is bent from the first side portion (24), the first side portion (24) having a first connection section (28) and a first extension section (30), the first connection section (28) connected to the first rail (10), the first extension section (30) having two support portions (32) between which a path (34) is defined, the first end board (26) having at least one front installation member (36);
a second rail (16) slidably connected to the first rail (10), the second rail (16) having two second sidewalls (44) and a second lateral wall (46), the second lateral wall (46) connected between the two second sidewalls (44), and
a support member (50) connected to one of the support portions (32) of the first support bracket (12), **characterized in that** there are two support members (50) which are respectively connected to the support portions (32) of the first support bracket (12), and
the support members (50) have a curved support face (52) facing the second sidewalls (44) of the second rail (16) so as to be engaged with the second sidewall (44) of the second rail (16), whereby when the second rail (16) is pulled relative to the first rail (10) to a position in the path (34) of the first support bracket (12), the curved support face (52) of the support member (50) contacts and supports the second rail (16), and wherein the support members (50a, 50b, 50c) and the first support bracket (12) are individual parts.

2. The support structure as claimed in claim 1, wherein the support members (50) extend from the first support bracket (12).

3. The support structure as claimed in claim 1 or claim 2, wherein the support members (50a, 50b, 50c) are connected to the first support bracket (12) by way of welding, riveting or engaging.

4. A slide assembly comprising a support structure according to claim 1, the slide assembly further comprising:
a second support bracket (14) having a second side portion (38) and a second end board (40), the second side portion (38) connected to a rear end of the first rail (10), the second end board (40) having at least one rear installation member (42); and
a third rail (18) slidably connected to the second rail (16) and having multiple positioning holes (48).

## Patentansprüche

1. Ein Träger, umfassend:
einer ersten Schiene (10);
einem ersten Stützwinkel (12) mit einem ersten Seitenteil (24) und einem ersten Endplättchen (26), das vom ersten Seitenteil (24) gebogen ist; das erste Seitenteil (24) mit einem ersten Verbindungssteg (28) und einem ersten Verlängerungsteil (30) gebildet ist; der erste Verbindungssteg (28) an der ersten Schiene (10) befestigt ist; das erste Verlängerungsteil (30) zwei Stützteile (32) aufweist, durch die ein Durchlass (34) gebildet ist; das erste Endplättchen (26) mindestens ein vorderes Installationsglied (36) aufweist;
einer zweiten Schiene (16), die gleitbar an der ersten Schiene (10) befestigt ist; die zweite Schiene (16) zwei zweite Seitenwände (44) und eine zweite seitliche Wand (46) aufweist; die zweite seitliche Wand (46) zwischen den beiden zweiten Seitenwänden (44) befestigt ist; und
einem Stützglied (50), das an einem der Stützteile (32) des ersten Stützwinkels (12) befestigt ist, **dadurch gekennzeichnet, dass** zwei Stützglieder (50) vorgesehen sind, die je an den Stützteilen (32) des ersten Stützwinkels (12) montiert sind, und
die Stützglieder (50) mit einer gebogenen Stützfläche (52) gegenüber den zweiten Seitenwände (44) der zweiten Schiene (16) gebildet sind, um die zweite Seitenwand (44) der zweiten Schiene (16) einzurasten, wobei beim Ziehen der zweiten Schiene (16) an der ersten Schiene (10) in eine Position im Durchlass (34) des ersten Stützwinkels (12) die gebogene Stützfläche (52) des Stützgliedes (50) mit der zweiten Schiene (16) in Berührung kommt und diese trägt und dabei die Stützglieder (50a, 50b, 50c) und der erste Stützwinkel (12) als Einzelteile gebildet sind.

2. Der Träger nach Anspruch 1, wobei sich die Stützglieder (50) vom ersten Stützwinkel (12) erstrecken.

3. Der Träger nach Anspruch 1 oder 2, wobei die Stützglieder (50a, 50b, 50c) durch Schmelzen, Vernieten oder Einrasten am ersten Stützwinkel (12) befestigt sind.

4. Ein Gleitmechanismus mit einem Träger nach Anspruch 1, wobei der Gleitmechanismus weiter aus den folgenden Komponenten umfassend:
einem zweiten Stützwinkel (14) mit einem zweiten Seitenteil (38) und einem zweiten Endplättchen (40); das zweite Seitenteil (38) an einem hinteren Ende der ersten Schiene (10) befestigt ist und das zweite Endplättchen (40) mindestens ein hinteres Installationsglied (42) aufweist; und
einer dritten Schiene (18), die gleitbar an der zweiten Schiene (16) montiert und mit mehreren Positionierlöchern (48) gebildet ist.

## Revendications

1. Une structure de support, comprenant :
un premier rail (10) ;
un premier support (12) ayant une première partie latérale (24) et une première plaque d'extrémité (26) qui est recourbée à partir de la première partie latérale (24), la première partie latérale (24) ayant une première section de connexion (28) et une première section d'extension (30), la première section de connexion (28) reliée au premier rail (10), la première section d'extension (30) ayant deux partie de support (32) entre lesquelles une trajectoire (34) est définie, la première plaque d'extrémité (26) ayant au moins un élément d'installation avant (36) ;
un second rail (16) relié de manière coulissante au premier rail (10), le second rail (16) ayant deux seconds flancs (44) et une seconde paroi latérale (46), la seconde paroi latérale (46) reliée entre les deux seconds flancs (44), et
un élément de support (50) relié à l'une des parties de support (32) du premier support (12), **caractérisé en ce qu'**il y a deux parties de support (50) qui sont respectivement reliées aux parties de support (32) du premier support (12), et
les éléments de support (50) ont une face de support incurvée (52) faisant face aux seconds flancs (44) du second rail (16) de sorte à être en prise avec le second flanc (44) du second rail (16), selon lequel le second rail (16) est écarté du premier rail (10) vers une position dans la trajectoire (34) du premier support (12), la face de support incurvée (52) de l'élément de support (50) vient en contact et supporte le second rail (16), et dans lequel l'élément de support (50a, 50b, 50c) et le premier support (12) sont des pièces individuelles.

2. La structure de support selon la revendication 1, dans lequel les éléments de support (50) s'étendent à partir du premier support (12).

3. La structure de support selon la revendication 1 ou la revendication 2, dans lequel les éléments de support (50a, 50b, 50c) sont reliés au premier support (12) par soudage, rivetage ou engagement.

4. Un ensemble coulissant comprenant une structure de support selon la revendication 1, l'ensemble coulissant comprenant en outre :
un deuxième support (14) ayant une deuxième partie latérale (38) et une deuxième plaque d'extrémité (40), la seconde partie latérale (38) reliée à une extrémité arrière du premier rail (10), la deuxième plaque d'extrémité (40) ayant au moins un élément d'installation arrière (42) ; et
un troisième rail (18) relié de manière coulissante au second rail (16) et ayant de multiples trous de positionnement (48).
